# EUROPEAN PATENT APPLICATION

(11) **EP 4 835 174 A1**
(43) Date of publication of application: **04.11.2026**
(21) Application number: 24912353.0
(22) Date of filing: 10.12.2024
(51) Int. Cl.: C30B 29/12, G02B 1/02, G02B 21/00, H01S 3/04

(54) **FLUORIDE CRYSTAL, WINDOW MATERIAL USING FLUORIDE CRYSTAL, LASER OSCILLATOR, OPTICAL ELEMENT, AND OPTICAL DEVICE**

(30) Priority: 27.12.2023 JP 2023220262
(71) Applicant: NIKON CORPORATION, Tokyo 140-8601 (JP)
(72) Inventor: KATO, Katsuyoshi, Tokyo 140-8601 (JP); SATO, Hiroki, Tokyo 140-8601 (JP)
(74) Representative: Viering, Jentschura & Partner mbB Patent- und Rechtsanwälte
(86) International application number: PCT/JP2024/043641
(87) International publication number: WO 2025/142464

(57) **Abstract**

A fluoride crystal comprising, on a mass basis, Mg in an amount of 2 ppm or more and 420 ppm or less, and Sr in an amount of 300 ppm or more and 55% (5.5 × 10⁵ ppm) or less.

## Description

### Technical Field

The present invention relates to a fluoride crystal, and a window material, a laser oscillator, an optical element, and an optical apparatus using the fluoride crystal. The present invention claims priority to Japanese Patent Application No. 2023-220262 filed on December 27, 2023, and, for designated states in which incorporation by reference of documents is permitted, the contents described in that application are incorporated herein by reference.

### Background Art

Patent Document 1 discloses an apparatus and a method for producing a fluoride crystal. Fluorite is mentioned as an example of a fluoride crystal. Fluorite is widely used as an optical material, but has a drawback in that it is easily cracked from the viewpoint of mechanical strength.

### Prior Art Documents

### Patent Documents

PTL 1 : JP2003-342098A

### Summary of the Invention

One aspect according to the present invention is a fluoride crystal comprising, on a mass basis, 2 ppm or more and 420 ppm or less of Mg, and 300 ppm or more and 55% (5.5 × 10^5 ppm) or less of Sr.

Another aspect according to the present invention is a window material using the fluoride crystal described above.

Another aspect according to the present invention is a laser oscillator using the fluoride crystal described above.

Another aspect according to the present invention is an optical element using the fluoride crystal described above.

Another aspect according to the present invention is an optical apparatus comprising the optical element described above.

### Brief Description of the Drawings

FIG. 1A is a schematic view illustrating an example of a configuration of a laser oscillator using the fluoride crystal according to the present embodiment.
FIG. 1B is a schematic view illustrating another example of the configuration of the laser oscillator using the fluoride crystal according to the present embodiment.
FIG. 2 is a perspective view illustrating an example in which the optical apparatus according to the present embodiment is an imaging apparatus.
FIG. 3 is a block diagram illustrating an example of a configuration of a microscope according to the present embodiment.
FIG. 4 is a block diagram illustrating an example of a configuration of an exposure apparatus according to the present embodiment.

### Description of Embodiment

Hereinafter, embodiments according to the present invention (hereinafter referred to as "the present embodiment") will be described. The following embodiments are examples for describing the present invention, and are not intended to limit the present invention to the following contents. The present invention may be implemented with appropriate modifications within the scope of the gist thereof.

In the present specification, unless otherwise specified, the content ratio of an element to be added indicates the content amount in a cation state in ppm on a mass basis. ppm on a mass basis is synonymous with "mg/kg".

Fluorite (calcium fluoride) is an isotropic material having a wide transmission wavelength range, and therefore is widely used as an optical material. However, from the viewpoint of mechanical strength, fluorite has a problem in that it is easily cracked, that is, plastic deformation (Slip). Mechanical strength is generally improved by doping with other elements (solid-solution strengthening), but most dopant elements deteriorate the laser durability of fluorite (the decrease in transmittance during laser irradiation becomes large). In addition, there is a limit to the doping concentration for each element (solid solubility limit). Ca colloids reduce transmittance at wavelengths of 200 nm or less, generate crystal defects at wavelengths near 380 nm, and aggregate the crystal defects at wavelengths near 560 nm.

In the present embodiment, various studies were conducted using the load at the occurrence of plastic deformation (Slip) as an index for evaluating mechanical strength. Further, various studies were conducted using, as durability indices, the maximum value of transmittance decrease near a wavelength of 560 nm (peak near 560 nm), and the ratio of the maximum value of transmittance decrease near a wavelength of 560 nm to the maximum value of transmittance decrease near a wavelength of 380 nm (peak near 560 nm/peak near 380 nm).

### <Fluoride Crystal>

The fluoride crystal according to the present embodiment comprises, on a mass basis, 2 ppm or more and 420 ppm or less of Mg, and 300 ppm or more and 55% (5.5 × 10^5 ppm) or less of Sr. The lower limit of the Mg content may be 4 ppm, may be 7 ppm, or may be 10 ppm. The upper limit of the Mg content may be 200 ppm, may be 150 ppm, or may be 100 ppm. Further, the lower limit of the Sr content may be 400 ppm, may be 800 ppm, or may be 1000 ppm. The upper limit of the Sr content may be 50% (5.0 × 10^5 ppm), may be 40% (4.0 × 10^5 ppm), may be 20% (2.0 × 10^5 ppm), or may be 10% (1.0 × 10^5 ppm).

The ratio (Mg/Sr) of the Mg content to the Sr content in the fluoride crystal according to the present embodiment is more than 0 and 0.5 or less on a mass basis. The lower limit of the Mg/Sr ratio may be 0.000001, may be 0.00001, or may be 0.0001. The upper limit of the Mg/Sr ratio may be 0.3, may be 0.1, or may be 0.022.

In the fluoride crystal according to the present embodiment, Mg and Sr are added as dopant elements. By adding Mg and Sr to the fluoride serving as a base material at the above-described contents and content ratio, the strength and laser durability of the obtained fluoride crystal can be enhanced. Further, Mg and Sr are added in the form of halides, oxides, carbonates, nitrates, or sulfates, and are preferably added in the form of fluorides.

The base material of the fluoride crystal according to the present embodiment is CaF₂, BaF₂, or the like, and is preferably CaF₂. Since CaF₂ (fluorite) has a wide transmission wavelength range from ultraviolet to infrared, it is suitably used for optical members.

The fluoride crystal according to the present embodiment is preferably a single crystal. By forming a single crystal, since there are fewer grain boundaries compared with a polycrystal, high ultraviolet transmittance and optical homogeneity are obtained, and therefore the fluoride crystal is more suitably used for optical members.

### <Physical Properties of Fluoride Crystal>

Hereinafter, evaluation regarding the mechanical strength (high-temperature pressure test) and laser durability (X-ray irradiation test) of the fluoride crystal according to the present embodiment will be described.

### Mechanical Strength

The fluoride crystal according to the present embodiment is heated to 200°C and pressurized for 4 hours using a weight. By setting a high temperature, conditions under which the fluoride crystal is likely to Slip are established, and further, stress is applied to the fluoride crystal by pressurization.

After the high-temperature pressurization, the fluoride crystal is cooled to room temperature, birefringence is measured, and the presence or absence of Slip is evaluated based on the presence or absence of streak-like birefringence. The same test is repeated while increasing the thickness of the weight until Slip occurs, and the ease of Slip occurrence is evaluated based on the magnitude of the load (thickness of the weight) at which Slip occurred, thereby using it as an index of mechanical strength.

The fluoride crystal used in the high-temperature pressure test has a diameter of 50 mm and a thickness of 2 mm, and since the appearance of Slip depends on orientation, two surfaces are polished, and the surface orientations are each a (111) plane (orientation deviation amount from the (111) plane is 3 deg or less, preferably deviation amount 0 deg) .

The weight used in the high-temperature pressure test is a cylindrical weight made of tungsten. The diameter of the bottom surface of the weight is 30 mm.

In the fluoride crystal according to the present embodiment, when a tungsten weight (density: 19.3 g/cm^3) is used after high-temperature pressurization, Slip does not occur at a thickness of 25 mm or less. The upper limit of the thickness of the weight at which Slip does not occur may be 50 mm, may be 60 mm, or may be 100 mm. As described above, the fluoride crystal according to the present embodiment is a material in which Slip is unlikely to occur and which has high mechanical strength.

### X-ray Irradiation Test

The fluoride crystal according to the present embodiment is irradiated with X-rays for 5 hours. By irradiating with X-rays, defects in the fluoride crystal can be generated in an accelerated manner, and the durability of the fluoride crystal can be efficiently tested in a short time. The radiation source is a 4 kW Rh source, and the dose is 15 kGy/min. Thereafter, transmittance is measured to obtain a transmittance spectrum at wavelengths of 200 nm or more and 800 nm or less. A difference spectrum is calculated from the difference between the transmittance spectrum obtained before X-ray irradiation and the transmittance spectrum obtained after irradiation. That is, the obtained difference represents the amount of decrease in transmittance at each wavelength. The decrease in transmittance near a wavelength of 560 nm is derived from absorption by Ca colloids, and the decrease in transmittance near a wavelength of 380 nm is derived from absorption by F-centers, which are precursors of Ca colloids. The maximum value of the transmittance decrease near a wavelength of 560 nm (peak near 560 nm) was used as one durability index. Further, the ratio of the maximum value of the transmittance decrease near a wavelength of 560 nm (peak near 560 nm) to the maximum value of the transmittance decrease near a wavelength of 380 nm (peak near 380 nm) was used as another durability index. It can be said that the smaller each value is, the higher the durability of the glass material and the less likely Ca colloids are to be generated. The vicinity of a wavelength of 560 nm refers to, for example, wavelengths of 540 nm or more and 600 nm or less, and the vicinity of a wavelength of 380 nm refers to, for example, wavelengths of 370 nm or more and 450 nm or less. The position of the peak near 380 nm tends to shift toward the longer wavelength side as the doping amount of Sr increases.

The fluoride crystal used in the X-ray irradiation test has a diameter of 30 mm and a thickness of 5 mm. Optionally, two surfaces may be polished and the surface orientations may each be a (111) plane.

In the fluoride crystal according to the present embodiment, the maximum value of transmittance decrease (peak near 560 nm) at wavelengths of 540 nm or more and 600 nm or less is 1.2% or less. The upper limit of the maximum value of transmittance decrease at the wavelength may be 1.0%, may be 0.5%, or may be 0.3%. The lower limit of the maximum value of transmittance decrease at the wavelength is, for example, 0%. The maximum value of transmittance decrease at wavelengths of 540 nm or more and 600 nm or less indicates the transmittance decrease (absorbance) at the wavelength where the transmittance decrease (absorbance) is maximum within the range of wavelengths of 540 nm or more and 600 nm or less.

In the fluoride crystal according to the present embodiment, the ratio of the maximum value of transmittance decrease (peak near 560 nm) at wavelengths of 540 nm or more and 600 nm or less to the maximum value of transmittance decrease (peak near 380 nm) at wavelengths of 370 nm or more and 450 nm or less is 0.4 or less. The upper limit of the ratio may be 0.1. Further, the ratio may be 0. As described above, since the fluoride crystal according to the present embodiment has a small ratio of peak near 560 nm/peak near 380 nm, it is a highly durable glass material in which Ca colloids are unlikely to be generated.

### <Applications of Fluoride Crystal>

Since the fluoride crystal according to the present embodiment has excellent mechanical strength and laser durability as described above, it can be suitably used for optical elements, optical apparatuses, and the like. An example of the optical element is a laser window material. The laser window material may be used in a laser oscillator. Examples of the optical element further include lenses, prisms, mirrors, various window materials, beam splitters, polarization beam splitters, diffraction optical elements, and the like. Examples of optical systems using the optical elements include interchangeable lenses for cameras, objective lenses, projection lenses, radiation-resistant optical systems, and the like. These optical systems can be suitably applied to various optical apparatuses such as imaging apparatuses including interchangeable-lens cameras and fixed-lens cameras, microscope apparatuses such as fluorescence microscopes and particularly polarization microscopes, exposure apparatuses for semiconductors and flat panel displays, astronomical optical apparatuses, and the like.

### <Laser Window Material>

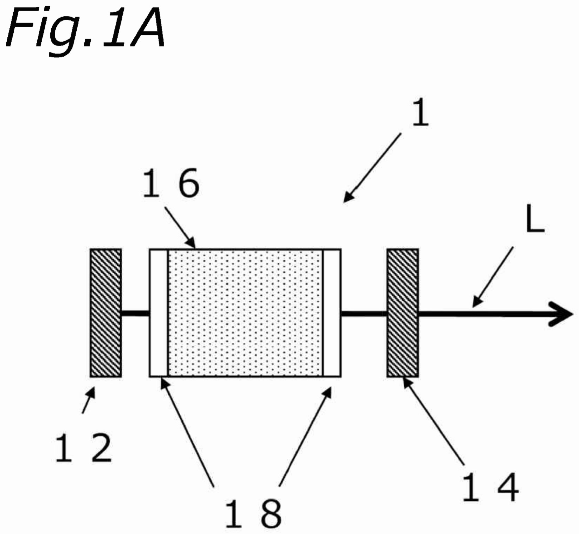

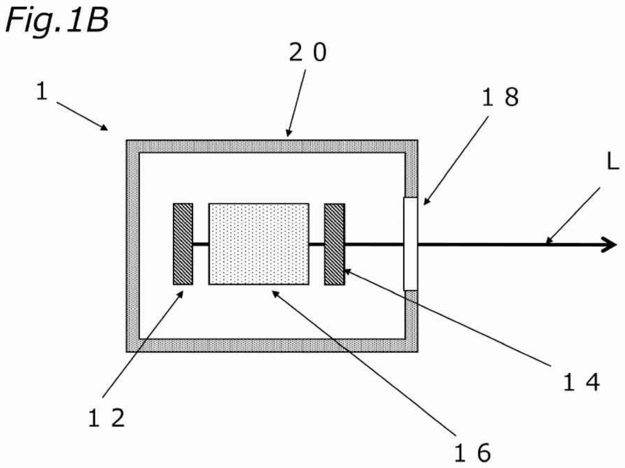

FIGS. 1A and 1B are schematic views illustrating a laser oscillator as an example of the laser window material according to the present embodiment. The laser oscillated by the laser oscillator is not particularly limited, and may be an excimer laser, a solid-state laser, a fiber laser, a gas laser, or the like. A laser oscillator 1 is composed of resonators 12 and 14, and a laser medium 16, and includes a window material 18 having, as a base material, the fluoride crystal according to the present embodiment. The laser medium 16 is disposed between the resonators 12 and 14 arranged in parallel to each other. As the resonator 12, one designed to totally reflect laser light L is used, and as the resonator 14, one designed to partially transmit the laser light L is used. The laser medium 16 is excited by excitation light (not illustrated), and the laser light L thereby generated is amplified by reciprocating between the resonators 12 and 14 and the laser medium 16. Then, a part of the laser light L oscillated from the laser medium 16 is extracted through the resonator 14. The window material 18 is provided between the resonators 12 and 14 as illustrated in FIG. 1A, for example, when positioned at both ends of the laser medium, or is provided in a housing 20 surrounding the resonators 12 and 14 and the laser medium 16 as illustrated in FIG. 1B. Furthermore, the laser window material according to the present embodiment may be used not only in the laser oscillator but also in a portion through which a laser passes in any optical apparatus (not illustrated). Since the fluoride crystal according to the present embodiment is less likely to generate Ca colloids due to ultraviolet irradiation causing a decrease in laser output and less likely to generate Slip accompanying stress loading causing deterioration of polarization degree, it can be suitably used for a laser window material.

### <Imaging Apparatus>

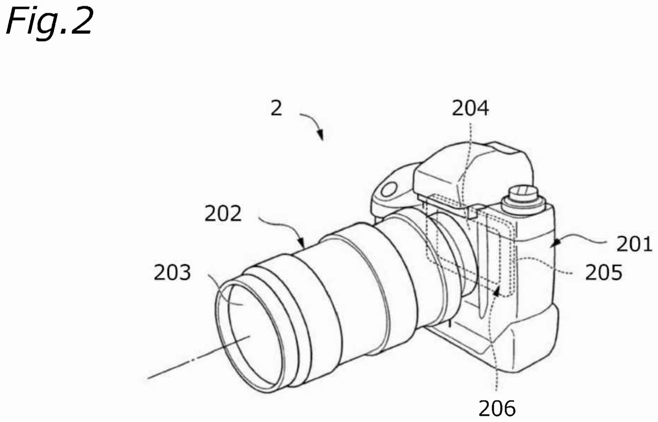

FIG. 2 is a perspective view illustrating an example in which the optical apparatus according to the present embodiment is an imaging apparatus. An imaging apparatus 2 is a so-called digital single-lens reflex camera (interchangeable-lens camera), and a photographing lens 103 (optical system) includes an optical element having, as a base material, the fluoride crystal according to the present embodiment. A lens barrel 202 is detachably attached to a lens mount (not illustrated) of a camera body 201. Then, light passing through a lens 203 of the lens barrel 202 is imaged on a sensor chip (solid-state imaging element) 204 of a multi-chip module 206 disposed on the rear side of the camera body 201. The sensor chip 204 is a bare chip such as a so-called CMOS image sensor, and the multi-chip module 206 is, for example, a COG (Chip On Glass) type module in which the sensor chip 204 is bare-chip-mounted on a glass substrate 205. When the fluoride crystal according to the present embodiment is used in an imaging apparatus, an element causing fluorescence may be intentionally prevented from being doped into the fluoride crystal.

### <Microscope>

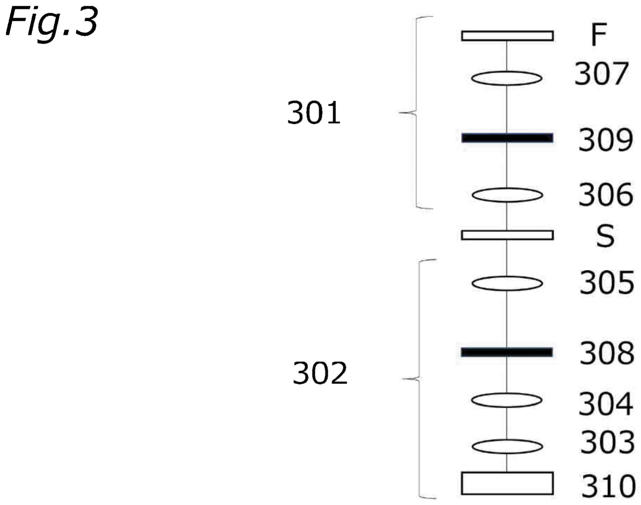

FIG. 3 is a block diagram illustrating an example of a configuration of a polarization microscope 3 according to the present embodiment. The polarization microscope 3 includes an illumination optical system 301 and an imaging optical system 302. The illumination optical system 301 includes a collector lens 303, a relay lens 304, a condenser lens 305, and the like, and the imaging optical system includes a first objective lens 306, a second objective lens 307, and the like. The illumination optical system 301 or the imaging optical system 302 includes at least one optical element having, as a base material, the fluoride crystal according to the present embodiment. Further, a polarization element 308 is provided between the relay lens 304 and the condenser lens 305, and a polarization element 309 is provided between the first objective lens 306 and the second objective lens 307. Hereinafter, the optical system of the polarization microscope 3 will be mainly described.

The illumination optical system 301 irradiates a sample S with natural light as illumination light, and the imaging optical system 302 forms an image of observation light emitted from the sample S. The natural light emitted from a light source 310 passes through the collector lens 303 and the relay lens 304 and enters the polarization element 308. The polarization element 308 polarizes the natural light and converts the natural light into polarized light. The polarized light is condensed by the condenser lens 305 and irradiated onto the sample S.

In this manner, the illumination optical system 301 irradiates the sample S with illumination light, and light thereby emitted from the sample S becomes observation light and enters the first objective lens 306. The light entering the first objective lens 306 is condensed by the first objective lens 306 and enters the polarization element 309. The polarization element 309 extracts light having desired polarization from the incident light, and the light having passed through the polarization element 309 enters the second objective lens 307.

The second objective lens 307 forms an image of the light having passed through the polarization element 309 at an image forming position F. An observer can observe the image formed at the image forming position F through an eyepiece lens or can capture the image with a desired imaging apparatus.

Since the fluoride crystal according to the present embodiment is less likely to generate Slip causing deterioration of polarization degree, it can be particularly suitably used for a polarization microscope.

### <Exposure Apparatus>

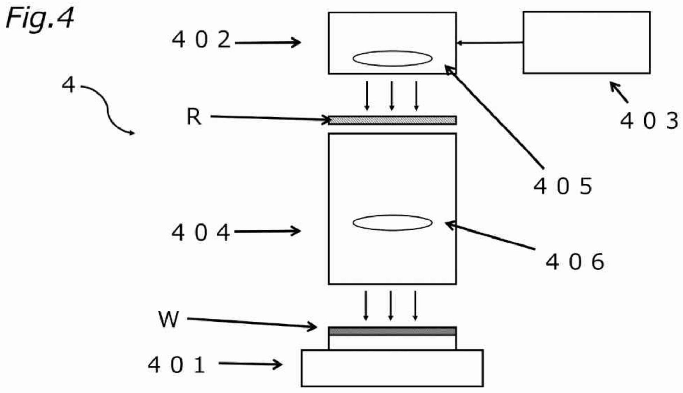

FIG. 4 illustrates an example of an exposure apparatus 4 according to the present embodiment, including a wafer stage 401 on which a wafer W (substrate) can be placed, an illumination optical system 402 that irradiates a reticle R (mask) with exposure light, a light source 403 that supplies exposure light to the illumination optical system 402, and a projection optical system 404 that projects a pattern of the reticle R onto the wafer W. The illumination optical system 402 includes a plurality of optical elements 405, and the projection optical system 404 includes a plurality of optical elements 406. These optical elements 405 and 406 are lenses, prisms, mirrors, filters, and the like.

The exposure apparatus according to the present embodiment may include an alignment optical system (not illustrated) that measures relative positions of the reticle R and the wafer W. The reticle R may be a transmissive reticle in which a desired pattern is drawn on a glass substrate, or may be a reflective reticle configured using micromirrors or the like. The exposure apparatus according to the present embodiment may include a reticle exchange system (not illustrated) that exchanges the reticle R irradiated by the illumination optical system 402.

The exposure apparatus according to the present embodiment includes at least one optical element having, as a base material, the fluoride crystal according to the present embodiment. In particular, it is preferable that at least one of the optical elements 405 included in the illumination optical system 402 and the optical elements 406 included in the projection optical system 404 have, as a base material, the fluoride crystal according to the present embodiment. Since the fluoride crystal according to the present embodiment is less likely to generate Ca colloids even when irradiated with high-energy laser light, it is suitably used for an exposure apparatus.

### [Examples]

Examples and comparative examples of the present invention will be described below. However, the present invention is not limited thereto.

### <Production of Fluoride Crystal>

An MgF₂ raw material and an SrF₂ raw material were mixed with a CaF₂ raw material and melted by a VGF (Vertical Gradient Freezing) method. Single crystal growth was performed by unidirectional solidification from a seed crystal as a starting point by adjusting heater output. The obtained single crystal material was annealed at a temperature of 1000°C or more and below the melting point to remove strain.

The method for producing the fluoride crystal according to the present embodiment is not particularly limited, and not only the VGF method but also known crystal growth methods such as a VB (Vertical Bridgman) method and a Cz (Czochralski) method can be used.

Test pieces (TPs) having desired shapes were sampled from the single crystal after annealing. In this case, the TP for mechanical strength testing was Φ50-t2 mm, and the TP for laser durability evaluation was Φ30-t5 mm, and two surfaces of each Φ50 mm and Φ30 mm were polished. The surface orientations of the polished surfaces were each a (111) plane. Since the appearance of Slip depends on orientation, a TP polished on a (111) plane is used for the mechanical strength test.

### <Mechanical Strength Evaluation>

The fluoride crystal according to the present embodiment (Φ50-t2 mm TP) was placed on a tungsten jig so that only 1 mm of the entire outer periphery was in contact. A tungsten weight having a diameter of Φ30 mm (manufactured by PLANSEE) was placed at the center of this TP, and in this state, a test was performed in which the TP was set in a tabletop electric furnace, held at 200°C for 4 hours, and then cooled. After cooling to room temperature, the TP was taken out and birefringence was measured (WPA-100-L manufactured by Photonic Lattice), and the presence or absence of Slip was evaluated based on the presence or absence of streak-like birefringence. The same test was repeated while increasing the thickness of the weight until Slip occurred, and the minimum thickness at which Slip occurred was used as an index of mechanical strength. The greater the thickness, the more highly durable the glass material was regarded as being less likely to generate Slip, and the thickness was compared with the addition concentration. Comparative Example 1 has a composition corresponding to existing fluorite. The results of the mechanical strength evaluation are shown in Tables 1 and 2.

**[Table 1]**

| | | Add Element / Concentration | | Mg/Sr | Thickness of the weight at the time of slip occurrence (mm) |
|---|---|---|---|---|---|
| | | Mg (ppm) | Sr (ppm) | | |
| Comparative Example **1** | | 2. 6 | 8. 1 | 0.32 | 10 |
| Comparative Example 2 | | 9. 1 | 12.5 | 0.73 | 25 |
| Comparative Example 3 | | 5.2 | 7.7 | 0.68 | 25 |
| | **Example 1** | 8. 9 | 416.1 | 0.021 | 55 |
| | **Example 2** | 6.6 | 857. 8 | 0.0077 | 60 |
| | **Example 3** | 12. 6 | 5050. 3 | 0.0024 | no Slip (~100) |

**[Table 2]**

| | Add Element / Concentration | | Mg/Sr | Thickness of the weight at the time of slip occurrence |
|---|---|---|---|---|
| | Mg (ppm) | Sr (%) | | (mm) |
| Example 1 0 | 5.3 | 0.52 | 1.02×10⁻³ | no Slip (~100) |
| Example 1 1 | 11 | 1. 1 | 1.00×10⁻³ | no Slip (~100) |
| Example 1 2 | 13 | 2. 2 | 5.91×10⁻⁴ | no Slip (~100) |
| Example 1 3 | 11 | 29 | 3. 79×10⁻⁵ | no Slip (~100) |
| Example 1 4 | 5.6 | 33 | 1. 70×10⁻⁵ | no Slip (~100) |
| Example 1 5 | 8.6 | 37 | 2.32×10⁻⁵ | no Slip (~100) |
| Example 1 6 | 3.5 | 41 | 8.54×10⁻⁶ | no Slip (~100) |
| Example 1 7 | 14 | 42 | 3.33×10⁻⁵ | no Slip (~100) |
| Example 1 8 | 30 | 40 | 7.50×10⁻⁵ | no Slip (~100) |
| Example 1 9 | 6.2 | 49 | 1.27×10⁻⁵ | no Slip (~100) |
| Example 2 0 | 11 | 48 | 2.29×10⁻⁵ | no Slip (~100) |
| Example 2 1 | 0.7 | 0.58 | 1.21×10⁻⁴ | no Slip (~100) |
| Example 2 2 | 0.4 | 37 | 1.08×10⁻⁶ | no Slip (~100) |
| Example 2 3 | 0.4 | 42 | 9.52×10⁻⁷ | no Slip (~100) |
| Example 2 4 | 110 | 0.071 | 1.55×10⁻¹ | no Slip (~100) |

From Tables 1 and 2, it was found that the higher the concentrations of Mg and Sr, the less likely Slip was to occur.

### <Laser Durability Evaluation>

The fluoride crystal according to the present embodiment (Φ30-t5 mm TP) was set in an XRF apparatus (ZSX Primus II manufactured by RIGAKU), and X-ray irradiation was performed for 5 hours. The radiation source was a 4 kW Rh source, and the dose was 15 kGy/min. After irradiation for 5 hours, transmittance measurement (Cary5000 manufactured by Agilent) was performed to obtain a transmittance spectrum at wavelengths of 200 nm or more and 800 nm or less. A difference spectrum was calculated from the difference between the transmittance spectrum obtained before X-ray irradiation and the transmittance spectrum obtained after irradiation. That is, the difference represents the amount of decrease in transmittance at each wavelength. The decrease in transmittance near a wavelength of 560 nm is derived from absorption by Ca colloids, and the decrease in transmittance near a wavelength of 380 nm is derived from absorption by F-centers, which are precursors of Ca colloids. The maximum value of the transmittance decrease near a wavelength of 560 nm (peak near 560 nm) was used as one durability index. Further, the ratio of the maximum value of the transmittance decrease near a wavelength of 560 nm to the maximum value of the transmittance decrease near a wavelength of 380 nm was used as another durability index. The smaller each value is, the more highly durable the glass material is in that Ca colloids are less likely to be generated. Comparative Example 4 has a composition corresponding to existing fluorite. The results of the laser durability evaluation are shown in Tables 3 and 4.

**[Table 3]**

| | | Add Element / Concetration | | Mg/Sr | Peak near 560 nm(%) | Peak near 560 nm /Peak near 380 nm |
|---|---|---|---|---|---|---|
| | | Mg (ppm) | Sr (ppm) | | | |
| Comparative Example 4 | | 2. 1 | 8. 2 | 0.26 | 8.4 | 1.4 |
| Comparative Example 5 | | 4. 5 | 9.3 | 0.48 | 1.6 | 0.5 |
| Conparataive Example 6 | | 4. 9 | 9.6 | 0. 51 | 1.3 | 0.5 |
| | Example 4 | 3.9 | 387. 1 | 0.010 | 1.2 | 0.4 |
| | Example 5 | 3.1 | 775.2 | 0.0040 | 1.0 | 0.5 |
| | Example 6 | 6 | 4447. 2 | 0.0013 | 0.3 | 0.2 |
| | Example 7 | 5.3 | 466. 1 | 0.011 | 0.8 | 0.3 |
| | Example 8 | 6.2 | 962. 6 | 0.0064 | 0.5 | 0.2 |
| | Example 9 | 7.7 | 4729. 1 | 0.0016 | 0.2 | 0. 1 |

**[Table 4]**

| | | Add Element/ Concentration | | Mg/Sr | Peak near 560 nm(%) | Peak near 560 nm /Peak near 380 nm |
|---|---|---|---|---|---|---|
| | | Mg (ppm) | Sr (%) | | | |
| Comparative Example 7 | | 1.2 | 0.67 | 1.79×10⁻⁴ | 3. 55 | 1. 76 |
| Comparative Example 8 | | 1.6 | 1 | 1.60×10⁻⁴ | 1.67 | 1. 36 |
| Comparative Example 9 | | 0.9 | 10 | 9.00×10⁻⁶ | 2.09 | 1. 47 |
| Comparative Example 10 | | 0.9 | 11 | 8.18×10⁻⁶ | 0.87 | 1. 19 |
| Comparative Example 11 | | 0.6 | 28 | 2.14×10⁻⁶ | 0.41 | 0. 69 |
| Comparative Example 12 | | 0.6 | 36 | 1.67×10⁻⁶ | 0. 32 | 0.48 |
| Comparative Example 13 | | 0.5 | 42 | 1.19×10⁻⁶ | 0.28 | 0. 56 |
| | Example 25 | 14 | 0.65 | 2.15×10⁻³ | 0. 45 | 0.22 |
| | Example 26 | 19 | 1 | 1.90×10⁻³ | 0.24 | 0. 13 |
| | Example 27 | 18 | 1 | 1.80×10⁻³ | 0.35 | 0.22 |
| | Example 28 | 9 | 1 | 9.00×10⁻⁴ | 0.41 | 0.30 |
| | Example 29 | 35 | 1.1 | 3.18×10⁻³ | 0.26 | 0. 12 |
| | Example 30 | 5. 8 | 1.4 | 4.14×10⁻⁴ | 0. 42 | 0.44 |
| | Example 31 | 9. 1 | 1.5 | 6.07×10⁻⁴ | 0. 28 | 0.27 |
| | Example 32 | 6 | 1.9 | 3.16×10⁻⁴ | 0.70 | 0. 29 |
| | Example 33 | 6.9 | 1.9 | 3.63×10⁻⁴ | 0.05 | 0.06 |
| | Example 34 | 21 | 6.4 | 3.28×10⁻⁴ | 0. 15 | 0. 08 |
| | Example 35 | 6. 3 | 11 | 5.73×10⁻⁵ | 0. 15 | 0. 19 |
| | Example 36 | 4. 5 | 9.9 | 4.55×10⁻⁵ | 0. 21 | 0. 27 |
| | Example 37 | 25 | 22 | 1.14×10⁻⁴ | 0.74 | 0.21 |
| | Example 38 | 4. 8 | 28 | 1.71×10⁻⁵ | 0.22 | 0. 25 |
| | Example 39 | 8. 1 | 30 | 2.70×10⁻⁵ | 0. 39 | 0. 25 |
| | Example 40 | 7. 1 | 29 | 2.45×10⁻⁵ | 0.40 | 0. 24 |
| | Example 41 | 35 | 34 | 1.03×10⁻⁴ | 0. 31 | 0. 29 |
| | Example 42 | 2. 4 | 31 | 7.74×10⁻⁶ | 0.25 | 0. 24 |
| | Example 43 | 41 | 31 | 1.32×10⁻⁴ | 0.35 | 0. 36 |
| | Example 44 | 4. 7 | 41 | 1.15×10⁻⁶ | 0.21 | 0.34 |
| | Example 45 | 6. 2 | 36 | 1.72×10⁻⁵ | 0.40 | 0. 36 |
| | Example 46 | 9. 9 | 37 | 2.68×10⁻⁵ | 0.21 | 0. 16 |
| | Example 47 | 14 | 44 | 3.18×10⁻⁵ | 0.63 | 0. 20 |
| | Example 48 | 8. 8 | 47 | 1.87×10⁻⁵ | 0.59 | 0. 37 |
| | Example 49 | 11 | 50 | 2.20×10⁻⁵ | 0.61 | 0.17 |
| | Example 50 | 28 | 0.034 | 8.24×10⁻² | 0.90 | 0.23 |
| | Example 51 | 13 | 0.078 | 1.67×10⁻² | 1. 04 | 0.32 |
| | Example 52 | 36 | 0.035 | 1.03×10⁻¹ | 0.78 | 0.17 |
| | Example 53 | 30 | 0.067 | 4.48×10⁻² | 0. 83 | 0. 24 |
| | Example 54 | 42 | 0.2 | 2.10×10⁻² | 0.58 | 0. 14 |
| | Example 55 | 15 | 0.071 | 2.11×10⁻² | 0.95 | 0. 32 |
| | Example 56 | 57 | 0. 1 | 5.70×10⁻² | 0.51 | 0.15 |
| | Example 57 | 56 | 0.087 | 6.44×10⁻² | 0.72 | 0. 20 |
| | Example 58 | 62 | 0.062 | 1.00×10⁻¹ | 0.82 | 0. 19 |
| | Example 59 | 108 | 0.067 | 1.61×10⁻¹ | 0. 66 | 0. 16 |
| | Example 60 | 413 | 0.097 | 4.26×10⁻¹ | 0. 73 | 0. 05 |
| | Example 61 | 96 | 0.074 | 1.30×10⁻¹ | 0.70 | 0.20 |

From Tables 3 and 4, it was found that the higher the concentrations of Mg and Sr, the less likely Ca colloids were to be generated and the higher the durability against laser irradiation.

From the above, it was found that Mg and Sr do not deteriorate laser durability, but rather improve the laser durability. It was experimentally clarified that co-doping these elements enables a fluoride crystal excellent in mechanical strength to be obtained.

### [Description of Reference Signs]

1: laser oscillator, 12: resonator, 14: resonator, 16: laser medium, 18: window material, 20: housing, L: laser light, 2: imaging apparatus, 201: camera body, 202: lens barrel, 203: lens, 204: sensor chip, 205: glass substrate, 206: multi-chip module, 3: polarization microscope, 301: illumination optical system, 302: imaging optical system, 303: collector lens, 304: relay lens, 305: condenser lens, 306: first objective lens, 307: second objective lens, 308: polarization element, 309: polarization element, 310: light source, S: sample, F: image forming position, 4: exposure apparatus, 401: wafer stage, 402: illumination optical system, 403: light source, 404: projection optical system, 405, 406: optical elements, W: wafer, R: reticle

## Claims

1. A fluoride crystal comprising, on a mass basis, 2 ppm or more and 420 ppm or less of Mg, and 300 ppm or more and 55% (5.5 × 10⁵ ppm) or less of Sr.

2. The fluoride crystal according to claim 1, wherein a ratio (Mg/Sr) of the Mg content to the Sr content on a mass basis is more than 0 and not more than 0.5.

3. The fluoride crystal according to claim 1 or 2, wherein a base material of the fluoride crystal is CaF₂.

4. The fluoride crystal according to any one of claims 1 to 3, wherein the fluoride crystal is a single crystal.

5. The fluoride crystal according to any one of claims 1 to 4, wherein no slip occurs upon heating at 200°C and pressurization for 4 hours.

6. The fluoride crystal according to claim 5, wherein no slip occurs when the pressurization is performed on a fluoride crystal having a diameter of 50 mm and a thickness of 2 mm using a tungsten weight having a diameter of 30 mm and a thickness of 25 mm or less.

7. The fluoride crystal according to any one of claims 1 to 6, wherein the maximum decrease in transmittance in a wavelength range of 540 nm or more and 600 nm or less after X-ray irradiation for 5 hours is 1.2% or less.

8. The fluoride crystal according to any one of claims 1 to 7, wherein a ratio of the maximum decrease in transmittance in a wavelength range of 540 nm or more and 600 nm or less to the maximum decrease in transmittance in a wavelength range of 370 nm or more and 450 nm or less after X-ray irradiation for 5 hours is 0.4 or less.

9. The fluoride crystal according to claim 7 or 8, wherein the X-ray irradiation is performed using a 4 kW Rh source at a dose of 15 kGy/min.

10. A window material comprising the fluoride crystal according to any one of claims 1 to 9.

11. A laser oscillator comprising the fluoride crystal according to any one of claims 1 to 9.

12. An optical element comprising the fluoride crystal according to any one of claims 1 to 9.

13. An optical apparatus comprising the optical element according to claim 12.
